# EUROPEAN PATENT APPLICATION

(11) **EP 2 573 807 A1**
(43) Date of publication of application: **27.03.2013**
(21) Application number: 11290430.5
(22) Date of filing: 23.09.2011
(51) Int. Cl.: H01L 21/762

(54) **Semiconductor structure and process for bird's beak reduction**

(71) Applicant: Soitec, 38190 Bernin (FR)
(72) Inventor: Bourdelle, Konstantin, 38920 Crolles (FR)
(74) Representative: Grünecker, Kinkeldey, Stockmair & Schwanhäusser

(57) **Abstract**

The present invention relates to a semiconductor structure including a bulk semiconductor; a thin semiconductor layer; an insulating layer between the bulk semiconductor and the thin semiconductor layer; a trench; and a side wall doped region, on at least a region of the inner surface of the trench.

## Description

The present invention relates to the manufacture of multilayer, wafers, in particular, ultra thin buried oxide (UTBOX) wafers particularly designed for the fabrication of CMOS devices. The invention, more particular, relates to a semiconductor structure including a bulk semiconductor, a thin semiconductor layer, an insulating layer between the bulk semiconductor and the thin semiconductor layer, and a trench.

Silicon on oxide (SOI) or ultra thin buried oxide (UTBOX) wafers are advantageously characterized by small variations of the threshold-voltage and, thus, of growing interest in present and future CMOS technology. In particular, the fully depleted CMOS technology allows for low-voltages and low-power circuits operating at high speeds. Moreover, fully depleted SOI devices are considered as most promising candidates for allowing for reduced short channel effects (SCE), particularly so with the nodes below 22nm.

Silicon on Insulator (SOI) wafers and, in particular, UTBOX wafers form the basis for the high-performance MOSFET and CMOS technology. The control of the SCE is mainly facilitated by the thinness of the active silicon layer formed above the insulator, i.e. buried oxide (BOX) layer. In order to reduce the coupling effect between source and drain and, furthermore, with respect to the scalability of thin film devices for future technologies, the provision of very thin BOX layers is mandatory. Control of the threshold voltage also depends of the thinness of the BOX layers. Appropriate implantation of the substrate below the BOX layer allows for accurate adjustment of the threshold voltage by back biasing.

In the manufacture of SOI devices, in particular CMOS devices, usually insulation trenches are formed, for example, in order to electrically isolate individual MOSFETs from each other. The formed trenches can be cleaned, slightly oxidized, and subsequently filled with an oxide liner and some insulator material above the liner and, thereby, shallow trench isolation (STI) structures are formed. However, in the manufacture of such trench structures, for example, STIs, a problem in the form of the so-called Birds's Beak Effect arise. The Birds's Beak Effect in the context of the formation of trenches in SOI wafers is characterized by the increase in the thickness of the BOX layer in the areas close to the edges of a trench.

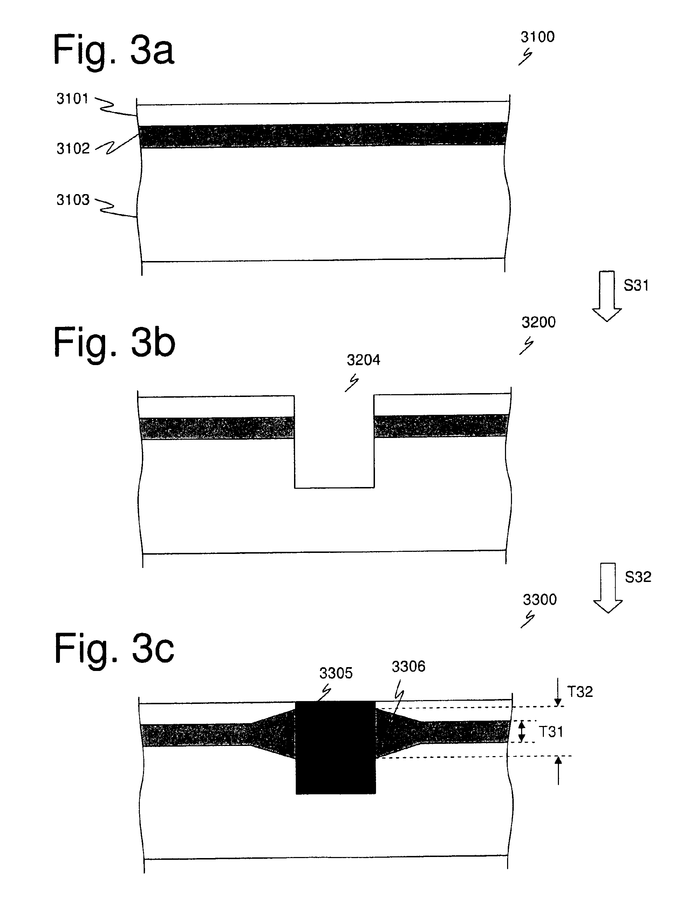

As can be seen in Figs. 3a-3c, a semiconductor structure 3100 consists of a bulk semiconductor 3103, above which a thin semiconductor layer 3101 is placed. The two elements are physically and electrically separated by at least insulating layer 3102.

Via a step S31, a semiconductor structure 3200 is obtained. The step S31 consists in the realization of insulation trench 3204. The purpose of insulation trench 3204 is to electrically insulate the thin semiconductor layer 3101 on its right side from the thin semiconductor layer 3101 on its left side.

Finally, via a step S32, a semiconductor structure 3300 is obtained. The step S32 consists of filling insulation trench 3204 with insulator 3305. As can be seen in Fig. 3c, the realization of the insulator 3305 causes the insulating layer 3102 to get thicker, the closer it is to the insulator 3305, this is referred to as bird's beak effect. This is illustrated in Fig. 3c where the thin insulating layer 3102 changes thickness from a value of T31 away from the insulator 3305, to a thicker value T32 in the proximity of insulator 3305.

One of the reasons behind the formation of birds's beak effect can be related to some underetching of the insulating layer 3102, for example, during a cleaning process that usually comprises hydrofluoric dipping. Another reason can be seen in lateral oxidation of a not completely closed bonding interface within the insulating layer 3102 layer in the case when the semiconductor structure 3100 is manufactured by oxide-oxide bonding wherein, for example, a thin semiconductor layer 3101 is covered by an oxide layer, for example, an SiO₂ layer, and transferred to a substrate that is also covered by an oxide layer of the same type.

The increase in thickness of the insulating layer 3102 implies that the electrical characteristics of transistors realized within the proximity of the trench 3204 are not constant. Or, that transistors cannot be realized within the proximity of the trench 3204. Both those situations are unacceptable especially in areas where high density SRAM arrays are fabricated.

Thus, there is a need for an improved method for the formation of trenches that alleviates the bird's beak effect.

The above mentioned problems are solved by the teaching of the independent claims.

More specifically, the present invention may relate to a semiconductor structure including: a bulk semiconductor; a thin semiconductor layer; an insulating layer between the bulk semiconductor and the thin semiconductor layer; a trench; and a side wall doped region, on at least a region of the inner surface of the trench.

Thanks to the usage of a side wall doping, at least part of the vertical walls of trench can be doped, thereby reducing the bird's beak effect in the doped region.

In some embodiments, the region can be at least the part of the inner surface of the trench interfacing with the insulating layer.

Thanks to such approach, doping can be realized only in the region interfacing with the insulating layer, so that the remaining surface of the trench is not doped. This could be advantageous in case where the remaining surfaces need to be, or already are, doped with a different dopant.

In some embodiments, the doped region can be doped with Nitrogen or Aluminum.

Thanks to such approach, the oxidation of the region around insulation layer is inhibited by the Nitrogen, or the Aluminum, thereby reducing the bird's beak effect.

In some embodiments, the bulk semiconductor can be configured to act as a back gate for devices realized on the thin semiconductor layer.

Thanks to such approach, better control of transistors realized on the thin semiconductor layer can be achieved.

In some embodiments, the bulk semiconductor can comprise or consists of silicon, in particular, single crystal silicon, or strained silicon, Ge or III-V layer.

In the UTBOX approach the bulk or handle substrate may be used for the fabrication of active areas: e.g. ground plate. In general the UTBOX family of substrates may be used for the application using hybrid-bulk technology where some components are fabricated on the SOI areas and others in the bulk areas, after removing the top this semiconductor layer and the insulating layer. B using the above-mentioned materials, the bulk semiconductor could be used both in the SOI and in the bulk area.

In some embodiments, the insulating layer can comprise or consists of SiO₂, a combination of SiO₂ and Si₃N₄ layers, or a combination of SiO₂ and Al₂O₃ layers

Thanks to such approach, the Nitrogen, or the Aluminum, is effective in inhibiting further oxidation of the insulating layer, causing the bird's beak effect.

In some embodiments, the thin semiconductor layer can comprise or consists of silicon, in particular, single crystal silicon, or strained silicon, Ge or III-V layer.

Thanks to such approach, it is possible to obtain transistors which have excellent electrical characteristics.

In some embodiments, the bulk semiconductor can have a thickness in the range 750µm to 800µm, preferably 775 µm. In some embodiments, the insulating layer can have a thickness in the range from 8nm to 30nm and more preferably a value of 10 nm. In some embodiments, the thin semiconductor layer can have a thickness in the range from 8nm to 20nm and more preferably a value of 12nm.

Thanks to such approach, it is possible to obtain transistors which have excellent electrical characteristics.

Furthermore, the present invention may relate to a method for the manufacture of a trench in a semiconductor structure, the semiconductor structure including a bulk semiconductor, a thin semiconductor layer, and an insulating layer between the bulk semiconductor and the thin semiconductor layer; the method including the steps of: realizing a trench; and side wall doping at least a region of the inner surface of the trench.

Thanks to the usage of a side wall doping, at least part of the vertical walls of trench can be doped, thereby reducing the bird's beak effect in the doped region.

In some embodiments, the step of sidewall doping can be realized by conformal plasma immersion or beam line implantation with the tilted target

Thanks to the plasma immersion doping technique, the step of side wall doping can be realized with high precision and throughput for high aspect ratio trenches. The beam line implantation can be used successfully in the case of lower aspect ratio trenches.

In some embodiments, the plasma immersion step can have an an energy range of 0.1 keV to 10 keV, or prefereably 3 keV and/or a dose range of 2E14/cm² to 2E16/cm2, or prefereably 5E15 /cm². Thanks to such approach, the doped layer achieves a depth effective in inhibiting the bird's beak problem.

Thanks to such approach, the side wall doping can be effective in reaching the depth needed for reducing the bird's beak effect.

In some embodiments, the method according to the previous embodiments may further comprise providing the semiconductor structure by: forming a first intermediate insulating layer above the bulk semiconductor; forming a second intermediate insulating layer above a semiconductor substrate; bonding the first and the second intermediate insulating layers, thereby obtaining the insulating layer, within a wafer transfer process and removing part of the semiconductor substrate, thereby obtaining the thin semiconductor layer.

The invention will be described in more detail by way of example hereinafter using advantageous embodiments and with reference to the drawings. The described embodiments are only possible configurations in which the individual features may however, as described above, be implemented independently of each other or may be omitted. Equal elements illustrated in the drawings are provided with equal reference signs. Parts of the description relating to equal elements illustrated in the different drawings may be left out. In the drawings:
Figs. 1a-2c illustrate schematic drawings of a semiconductor structure and a method for the realization of a trench, in accordance with an embodiment of the present invention;
Figs. 3a-3c illustrate schematic drawings of a semiconductor structure and a method for the realization of a trench, in accordance with the state of the art.

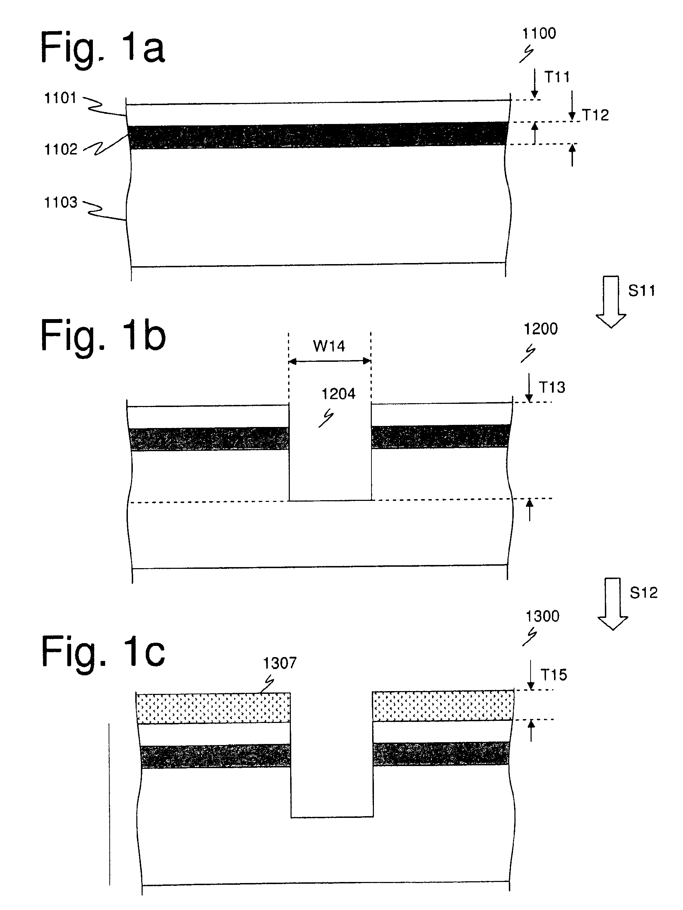

As can be seen in Fig. 1 a, a semiconductor structure 1100 includes a thin semiconductor layer 1101, an insulating layer 1102 and a bulk semiconductor 1103. The thin semiconductor 1101 may be any of single crystal silicon, strained silicon, Ge or III-V layer. The insulating layer 1102 may be any of SiO2, a combination of SiO₂ and Si₃N₄ layers, or a combination of SiO₂ and Al₂O₃ layers. The bulk semiconductor 1103 may be any of single crystal silicon strained silicon, Ge or III-V layer. The semiconductor structure 1100 may be obtained by a SmartCut® process. More specifically, this implies providing the semiconductor structure by forming a first intermediate insulating layer above the bulk semiconductor; forming a second intermediate insulating layer above a semiconductor substrate; bonding the first and the second intermediate insulating layers, thereby obtaining the insulating layer, within a wafer transfer process and removing part of the semiconductor substrate, thereby obtaining the thin semiconductor layer.

In order to realize fully-depleted (FD) transistors, the thin semiconductor layer 1101 may have a thickness T11 in the range of 8-20 nm or, preferably, 12 nm. The insulating layer 1102 may have a thickness T12 in the range of 8-30 nm or, preferably, 10 nm. The bulk semiconductor 1103 may have a thickness in the range of 750µm to 800µm or, preferably, 775µm.

In order to use the bulk semiconductor 1103 as a back gate for devices, such as FD transistors, realized on the thin semiconductor layer 1101, dopants can be implanted in the bulk semiconductor 1103.

Via a step S11 of realizing a trench 1204, semiconductor structure 1200 of Fig. 1b is obtained.

In the semiconductor structure 1200, a trench 1204 is formed through the thin semiconductor layer 1101 and at least part of the insulating layer 1102 and optionally extending into the bulk semiconductor 1103 as it is shown in Figure 1b. Formation of the trench may be facilitated by forming a mask layer, for example, a nitride mask layer atop of the thin semiconductor layer 1101 and a photoresist atop of the mask layer (not shown). After patterning the trench 1204 can be etched and both the mask layer and the photoresist are removed.

The trench 1204 has a depth T13 of 0.2 - 1 µm or, preferably 0.3 µm, and a width W14 of 0.1 - 0.5 µm. Generally, the depth and width of the trench 1204 are determined by the design rules.

After the formation of the trench 1204, via a step S12 of depositing a mask 1307, semiconductor structure 1300 of Fig. 1c is obtained.

In the semiconductor structure 1c, the mask 1307 can be deposited via CVD, PVD, nanoprint, etc. The mask 1307 has a thickness T15 of 50-200nm. The material of mask 1307 may be formed by subsequent deposition of silicon oxide and silicon nitride.

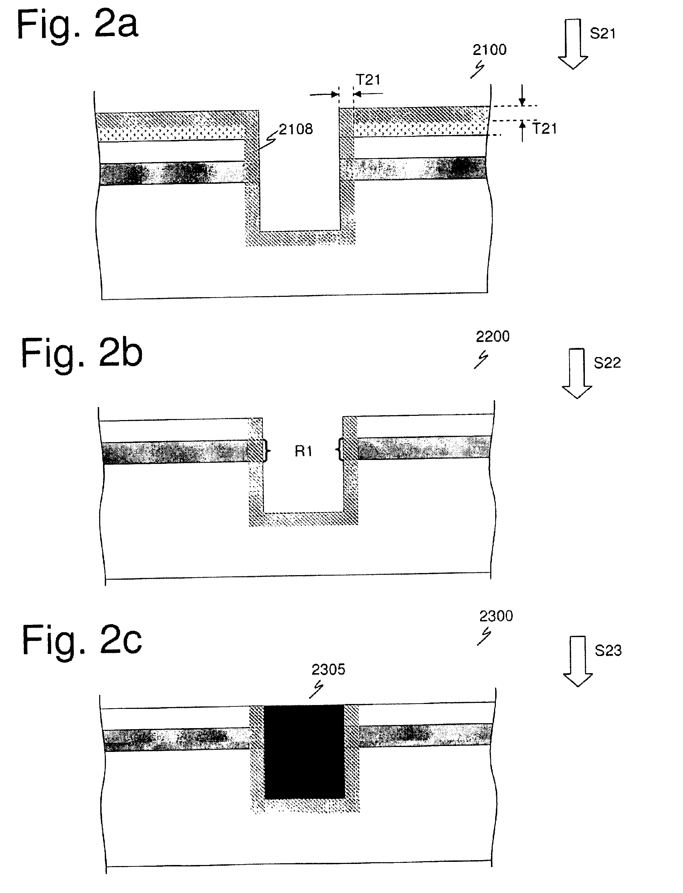

After the formation of the mask 1307, via a step S21 of side wall doping the trench 1204, semiconductor structure 2100 of Fig. 2a is obtained.

In the semiconductor structure 2100, a doped side wall region 2108 is realized. The side wall doped region has a thickness T21 of 5-40 nm range or, preferably 25 nm single value.

The side wall doped region 2108 is realized via plasma immersion having an energy range of 0.1keV to 10keV, preferably 3 keV and a dose range of 2E14 to 2E16/cm² or prefereably 5E15 /cm2. As an alternative to the plasma immersion technique, beam line implantation with the tilted target could be used. More specifically, by tilting the doping target, i.e. semiconductor structure 2100, it is possible to realize side wall doped region 2108 with a beam line implantation. This has the advantage that the technique may be faster and/or cheaper. This technique may be viable in the case of low aspect ratio trenches. In general, any doping technique that allows the side walls of the trench 1204 to be doped can be used. The dopant used for the doped region 2108 is Nitrogen or Aluminium. Nitrogen may be more efficient in suppressing the oxidation rate of silicon.

Although steps S11, S12 and S21 for the realization of the trench 1204 and for the doping of the trench 1204 have been described as separate, the present invention is not limited to this. Alternatively, the mask 1307 used for the doping of the trench 1204, such as in step S21, could be the same mask used for the realization of the trench 1204, during step S11, thereby avoiding using two masks. For instance the trench etch may be done after deposition of a hard mask, photolithographic definition of the STI areas, and subsequent plasma etch with the stop on top Si layer. The implant step could be performed after trench formation. The hard mask in such configuration acts as a protector of the top Si layer from the nitrogen doping.

After the formation of the side wall doped region 2108, via a step S22 of removing the mask 1307, semiconductor structure 2200 of Fig. 2b is obtained.

As can be seen in Fig. 2b, semiconductor structure 2200 includes the doped region 2108 only on the inner walls of trench 1204. In this manner, when the trench 1204 is subsequently filled with an insulation material, or when the semiconductor structure 2200 undergoes any temperature process, such as anneal, the bird's beak effect is mitigated. This is due to the Nitrogen effect of reducing the oxidation rate.

Although Fig. 2b illustrates the doped region 2108 on the entire inner walls of trench 1204, the present invention is not limited to this. Alternatively, the doped region 2108 could be only realized on a region R1 of the inner walls of trench 1204, in the proximity of insulating layer 1102. This could be achieved, for instance, by using an appropriate mask when carrying out step S21.

After the removal of mask 1307, via a step S23 of filling the trench 1204, semiconductor structure 2300 of Fig. 2c is obtained.

The trench is filled with Si dioxide or multiple Si dioxide/ Si nitride 2305. By using such a filled trench, different individual MOSFETs, for example, can be electrically insulated from each other. The insulated MOSFETs may be of different conductivity types and may be part of a CMOS device.

Alternatively, or in addition, the above-described manner of forming the trench structure may also be used for the formation of a trench capacitor and, in particular, for the formation of a memory cell, for example, a DRAM cell on SOI, comprising such a trench capacitor. For this purpose, on the inner surfaces of the trench 1204 a node dielectric, for example, of silicon nitride or silicon oxide, is formed and, subsequently, the trench 1204 is filled with a electrically conductive material, for example, a metal like copper, nickel, etc, or n+ doped polysilicon. Such a trench capacitor can be connected to an access transistor that is also formed on and partially in the multilayer wafer.

All previously discussed embodiments are not intended as limitations but serve as examples illustrating features and advantages of the invention. It is to be understood that some or all of the above described features can also be combined in different ways.

## Claims

1. A semiconductor structure (1400, 1500, 1600) including:
a bulk semiconductor (1103);
a thin semiconductor layer (1101);
an insulating layer (1102) between the bulk semiconductor (1103) and the thin semiconductor layer (1101);
a trench (1204); and
a side wall doped region (2108), on at least a region (R1) of the inner surface of the trench (1204).

2. The semiconductor structure according to claim 1 wherein
the region (R1) is at least the part of the inner surface of the trench (1204) interfacing with the insulating layer (1102).

3. The semiconductor structure according to claim 1 or 2 wherein
the doped region (2108) is doped with Nitrogen or Aluminium.

4. The semiconductor structure according to any of the previous claims wherein the bulk semiconductor (1103) is configured to act as a back gate for devices realized on the thin semiconductor layer (1101).

5. The semiconductor structure according to any of the previous claims wherein
the bulk semiconductor (1103) comprises or consists of silicon, in particular, single crystal silicon, or strained silicon, Ge or III-V layer.

6. The semiconductor structure according to any of the previous claims wherein
the insulating layer (1102) comprises or consists of SiO₂, a combination of SiO₂ and Si₃N₄ layers or a combination of SiO₂ and Al₂O₃ layers.

7. The semiconductor structure according to any of the previous claims wherein
the thin semiconductor layer (1101) comprises or consists of silicon, in particular, single crystal silicon, or strained silicon, Ge or III-V layer.

8. The semiconductor structure according to any of the previous claims wherein
the bulk semiconductor (1103) has a thickness in the range of 750µm to 800µm, preferably 775 µm.

9. The semiconductor structure according to any of the previous claims wherein
the insulating layer (1102) layer has a thickness (T12) in the range from 8nm to 30nm and more preferably a value of 10 nm.

10. The semiconductor structure according to any of the previous claims wherein
the thin semiconductor layer (1101) has a thickness (T11) in the range from 8nm to 20nm and more preferably a value of 12nm.

11. A method for the manufacture of a trench in a semiconductor structure, the semiconductor structure including a bulk semiconductor (1103), a thin semiconductor layer (1101), and an insulating layer (1102) between the bulk semiconductor (1103) and the thin semiconductor layer (1101); the method including the steps of:
realizing (S11) a trench (1204); and
side wall doping (S21) at least a region (R1) of the inner surface of the trench (1204).

12. The method according to claim 11, wherein the strep of side wall doping (S21) is realized by conformal plasma immersion implantation or beam line implantation with the tilted target.

13. The method according to claim 12 wherein the plasma immersion step has an energy range of 0.1 keV to 10 keV, or prefereably 3 keV and/or a dose range of 2E14/cm² to 2E16/cm², or prefereably 5E15/cm².

14. The method according to any of claims 11 to 13, further comprising providing the semiconductor structure by:
forming a first intermediate insulating layer above the bulk semiconductor (1103);
forming a second intermediate insulating layer above a semiconductor substrate;
bonding the first and the second intermediate insulating layers, thereby obtaining the insulating layer (1102), within a wafer transfer process and removing part of the semiconductor substrate, thereby obtaining the thin semiconductor layer (1101).
